# EUROPEAN PATENT SPECIFICATION

(11) **EP 4 038 479 B1**
(45) Date of publication and mention of the grant of the patent: **15.07.2026**
(21) Application number: 20793806.9
(22) Date of filing: 29.09.2020
(51) Int. Cl.: G06F 3/01, G01M 17/007, G02B 27/01, G09B 9/04

(54) **A METHOD AND AN APPARATUS FOR CHECKING AND/OR CONFIGURING THE ARRANGEMENT OF THE PHYSICAL ELEMENTS OF A VEHICLE**
VERFAHREN UND VORRICHTUNG ZUM PRÜFEN UND/ODER KONFIGURIEREN DER ANORDNUNG DER PHYSISCHEN ELEMENTE EINES FAHRZEUGS
PROCÉDÉ ET APPAREIL DE VÉRIFICATION ET/OU DE CONFIGURATION DE L'AGENCEMENT DES ÉLÉMENTS PHYSIQUES D'UN VÉHICULE

(30) Priority: 30.09.2019 IT 201900017573
(43) Date of publication of application: 10.08.2022
(73) Proprietor: ITALDESIGN-GIUGIARO S.p.A, 10121 Torino (IT)
(72) Inventor: RIBET, Fabrizio, 10121 Torino (IT); TAMMARO, Elena Flaminia Dirce, 10121 Torino (IT); VALSANIA, Marco, 10121 Torino (IT); PICCIONI, Matilde, 10121 Torino (IT); GORIANZ, Remo, 10121 Torino (IT); FORLIN, Roberto, 10121 Torino (IT); BELMONTE, Vincenzo, 10121 Torino (IT)
(74) Representative: Savoca, Agatino
(86) International application number: PCT/IB2020/059089
(87) International publication number: WO 2021/064563

(56) References cited:
- EP-A2- 1 533 683
- DE-A1- 102015 003 884
- US-A- 5 583 526
- US-B1- 7 761 269

## Description

### Technical field

This invention is generally in the field of test methods and apparatuses; in particular, the invention relates to a method and an apparatus for checking and/or configuring the arrangement of the physical elements of a vehicle.

### Prior art

Test apparatuses are known for adjusting the arrangement of the physical parts of a vehicle passenger compartment which exploit the interaction with a virtual environment projected in 2D on walls external to the vehicle mock-up to simulate the real conditions of use.

An example of this apparatus is known from US 2015/0228199 A1 which illustrates a platform comprising a plurality of movable parts, around which it is possible to generate, by means of projectors, a virtual scene, representative of the conditions outside the passenger compartment.

An apparatus according to the aforesaid prior art document allows the position of the various physical elements constituting the apparatus so as to configure the latter in a predetermined operating position.

Nevertheless, the test equipment according to the aforesaid document does not allow the correspondence of this configuration, resulting from the adjustment procedure of the physical elements, with the structure and the operating conditions of a real vehicle to be fully evaluated, nor does it allow a sufficiently immersive virtual environment to be generated so that the simulation experience may extend to the widest possible variety of real vehicle configurations (for example, by fully replicating the interior of the passenger compartment, i.e. also reproducing its features such as finishes, colors, or vehicle components not physically included in the test apparatus).

These factors, understandably, limit the concrete overlap between the test conditions and the real use conditions of the vehicle.

To overcome these drawbacks, the prior art contemplates a plurality of solutions intended to superimpose a virtual scene on a real environment, such as the passenger compartment of a vehicle. Examples of such solutions are known from documents DE 10 2015 003884 A1, US 7 761 269 B1 and EP 1 533 683 A2. In certain solutions, the superimposition of the virtual and real environments is carried out by photogrammetric detection of the movement of a plurality of markers distributed on the body of the user (using the so-called "motion capture" technique).

Such an approach is characterized by the absence of an extrinsic reference system, as the movement and arrangement of physical entities is simulated on the basis of the positions that these entities assume directly in the virtual scene. In effect, the position of the physical bodies at a given instant is recorded by means of optical devices that capture the position of the markers associated with these physical elements, and the resulting signals from the optical devices are projected onto a virtual grid or background, so that the movement of the physical bodies is detected as the difference between the position that the markers assume in two different instants relative to this virtual background, which thus constitutes an intrinsic reference system.

The absence of a methodology for assigning an extrinsic reference system entails an increase in the computational cost of the simulation, because it makes it more complex to align the physical environment with the virtual scene.

### Summary of invention

An object of this invention is to overcome the aforementioned problems.

To obtain this result, this invention provides a method according to claim 1 and a test apparatus according to claim 5. The dependent claims define further embodiments of the invention.

An example of the present disclosure provides the steps for preparing a test apparatus, comprising one or more physical elements adjustable in position and/or orientation, predetermining a specific configuration thereof (which is to be subjected to a test to evaluate the features thereof such as ergonomics, design conformity, aesthetic performance, etc., with reference, for example, to the configurations of sports and commercial vehicles, etc.), by processing or acquiring a virtual model by means of an electronic processing unit.

Then, the physical elements of the apparatus are adjusted, until their position and/or their orientation coincide with those that the same elements have in the virtual model.

Subsequently, a user of the vehicle is interfaced with this electronic processing unit by means of a virtual reality viewer, which allows the user to immerse himself completely in the virtual model.

This would also make it possible to recreate and model the real vehicle almost entirely in the virtual environment, including those parts of the vehicle that do not have physical correspondents in the test apparatus (for example, a dashboard contoured according to a certain shape, when perhaps the test apparatus does not have an equivalent element) and/or to which one wishes to impart features (such as colors and finishes) that the corresponding physical parts of the test apparatus do not have.

The method further provides for defining a first reference point, the position of which is known in the physical environment, and measuring its distance from the second reference point on the virtual reality viewer, after which the user's point of view is positioned on the virtual reality viewer, according to that distance.

In this way, the user's view is linked to the virtual model, and, consequently, the portion that the user will see of the virtual model will depend on the real movements of his head.

The aforesaid and other objects and advantages are achieved, according to an aspect of the invention, by a method and an apparatus having the features defined in the appended claims.

### Brief description of the drawings

The functional and structural features of some preferred embodiments of a method and an apparatus according to the invention will now be described. Reference is made to the accompanying drawings, wherein:
- Fig. 1 is a schematic perspective view of a test apparatus, according to an embodiment of this invention;

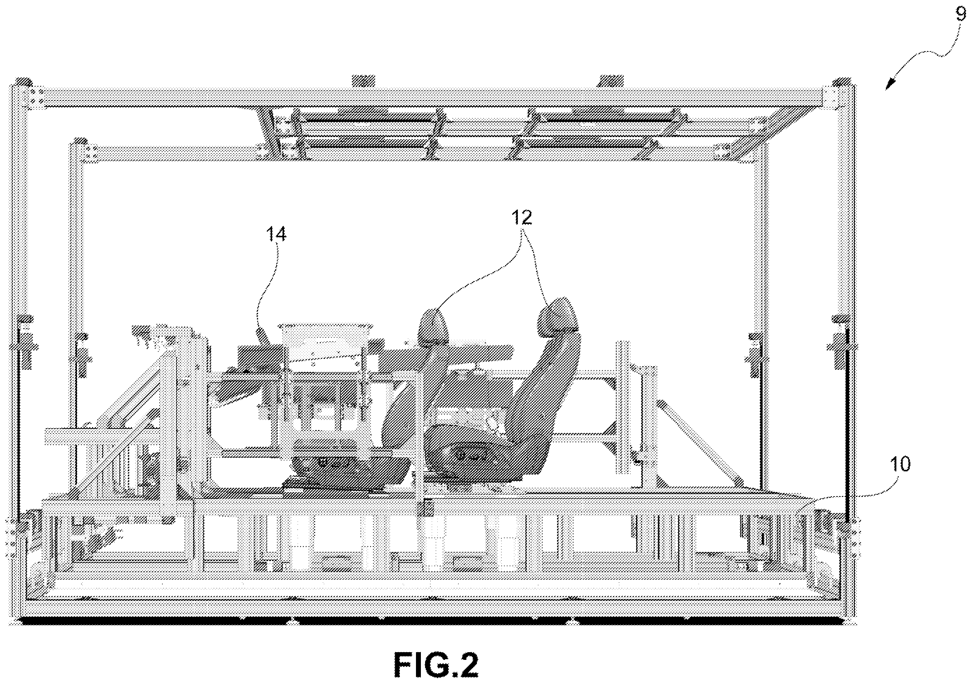

- Fig. 2 is a schematic side view of the test apparatus in Fig. 1;

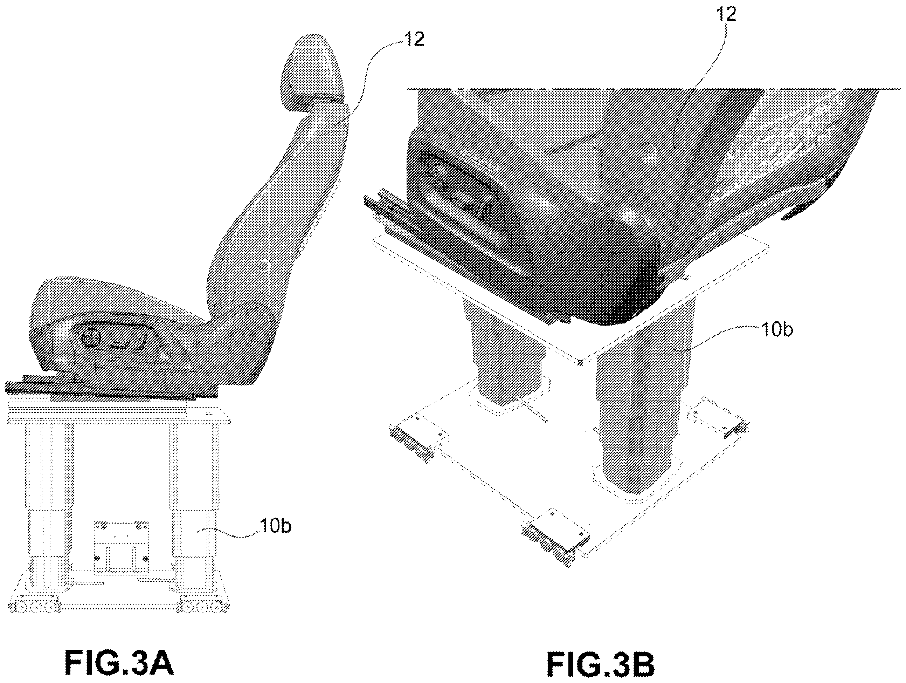

- Fig. 3A and 3B are respectively a side schematic view of a seat that may be incorporated into the test apparatus, and an enlargement of this seat, according to an embodiment of this invention;

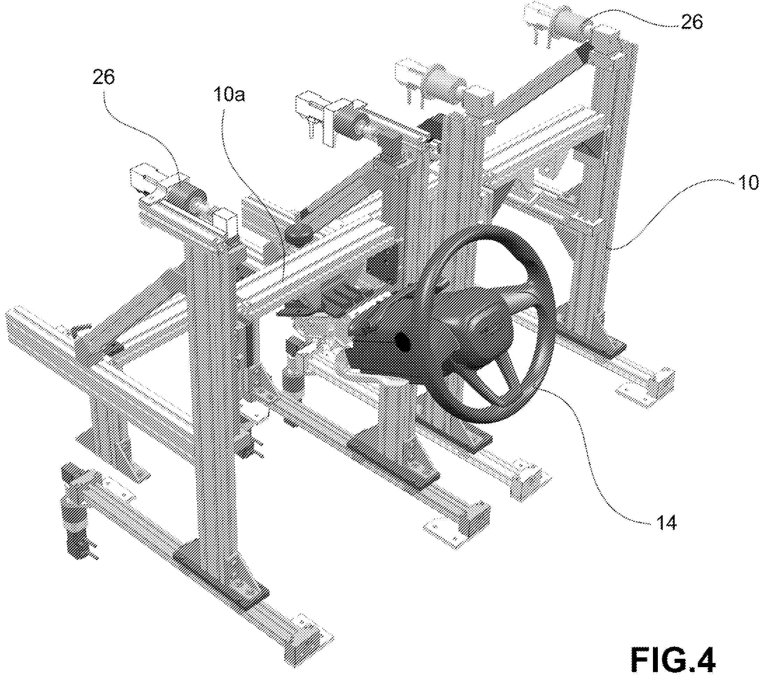

- Fig. 4 is a schematic perspective view of a steering wheel that may be incorporated into the test apparatus, according to an embodiment of this invention;

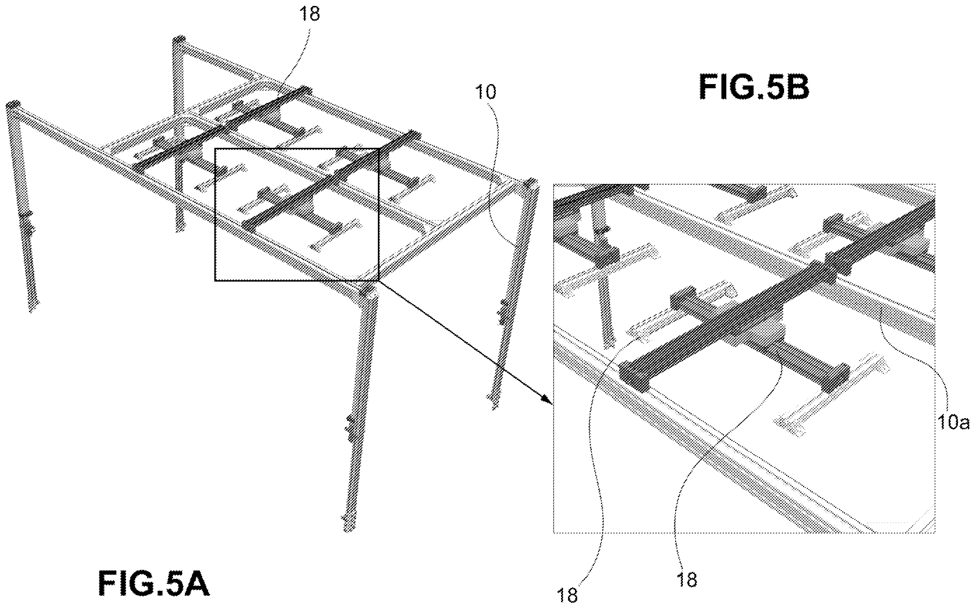

- Fig. 5A and 5B are respectively a schematic perspective view of a structure (which may be incorporated into the test apparatus) which simulates the roof of a vehicle, and of an enlargement of this structure, according to an embodiment of this invention;

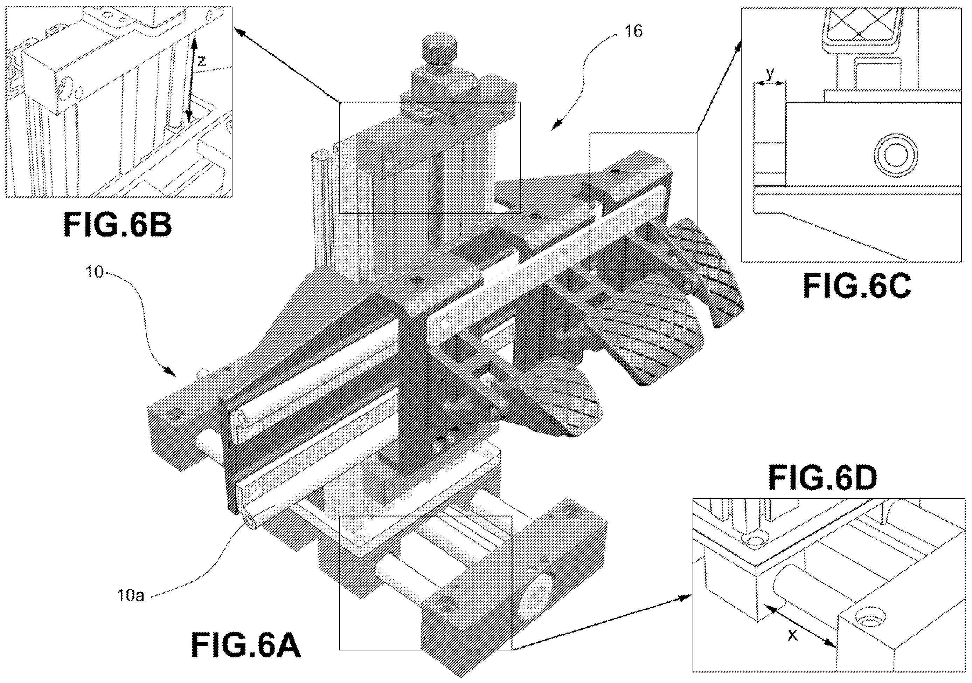

- Fig. 6A to 6D are respectively a schematic perspective view of a pedalboard, which may be incorporated into the test apparatus, and of a plurality of enlargements of this pedalboard, according to an embodiment of this invention; and

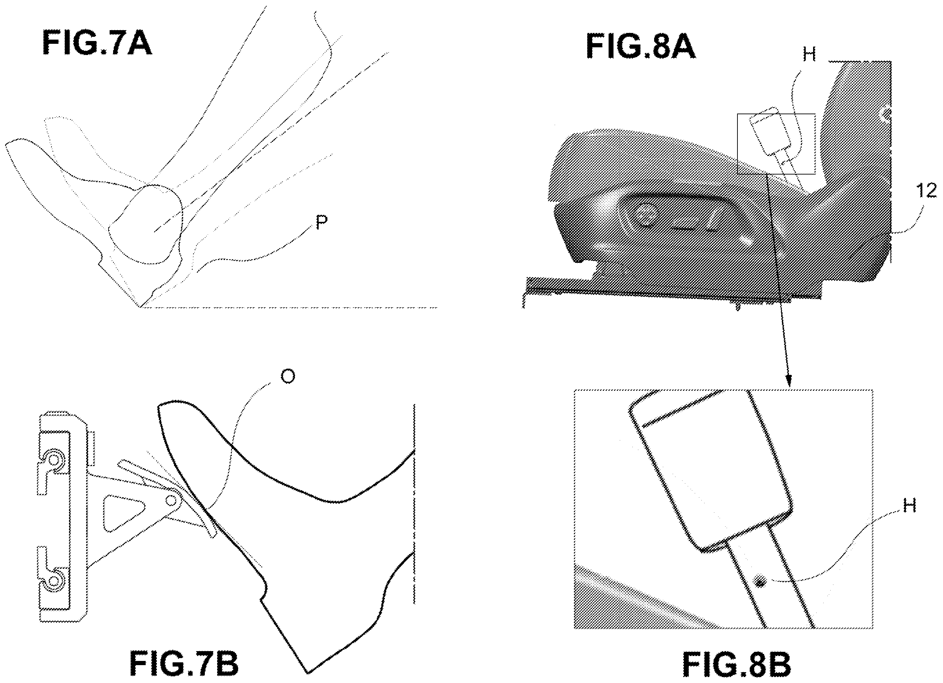

- Fig. 7A to 8B are schematic views of steps of the method for checking and/or configuring the arrangement of the physical elements of a vehicle, wherein parts of the test apparatus are positioned as reference points (respectively, a point indicative of a standard position of the user's heel, a point indicative of a position of the user's foot, and a point indicative of a rearmost and lowermost position of a seat relative to the front of the vehicle), so that positions and/or orientations of these parts of the apparatus, relative to the support structure of the test apparatus, coincide with the positions and/or orientations that these parts of the apparatus have in a pre-processed or pre-acquired virtual model, according to an embodiment of the invention.

### Detailed description

Before describing in detail a plurality of embodiments of the invention, it should be clarified that the invention is not limited in its application to the construction details and configuration of the components presented in the following description or illustrated in the drawings. The invention is capable of assuming other embodiments and of being implemented or constructed in practice in different ways. It should also be understood that the phraseology and terminology have a descriptive purpose and should not be construed as limiting.

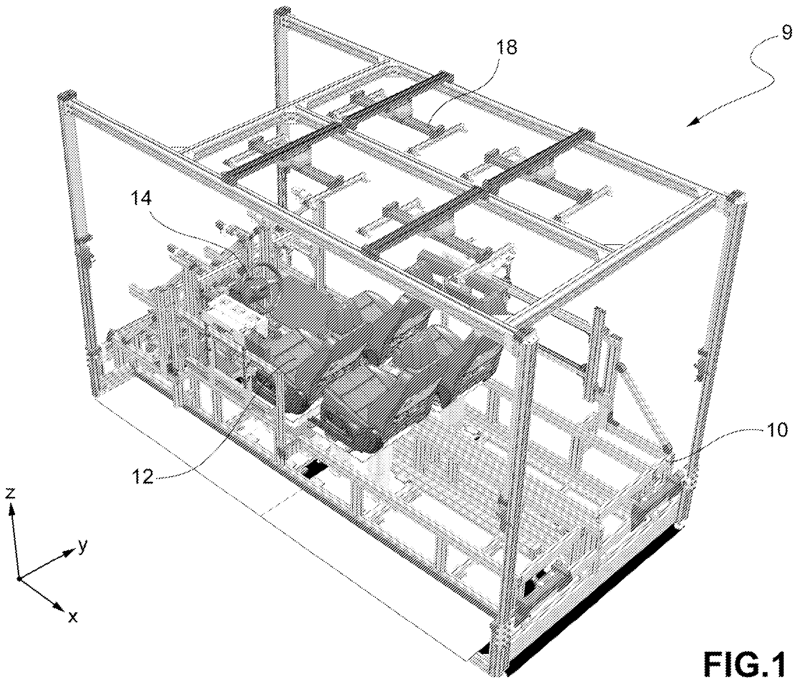

Referring by way of example to Fig. 1, a method for checking and/or configuring the arrangement of the physical elements of a vehicle comprises the steps of preparing a test apparatus 9, adapted to simulate the arrangement of the physical elements of the vehicle.

This test apparatus 9 comprises a support structure 10, to which one or more physical elements 12, 14, 16, 18, 20, 22 are joined, the position and/or orientation of which are adjustable with respect to the support structure 10.

Said physical elements 12, 14, 16, 18, 20, 22 comprise at least a seat 12, and/or a steering wheel 14, and/or a pedalboard 16, and/or a roof 18, and/or at least one door, and/or an armrest for a user of the test apparatus 9, and/or a compartment used as a trunk.

The method further comprises the step of:
acquiring or processing, by means of an electronic processing unit, a virtual model representative of an arrangement of the one or more physical elements 12, 14, 16, 18, 20, 22 relative to the support structure 10 of the test apparatus; arranging the one or more physical elements 12, 14, 16, 18, 20, 22 according to said arrangement, in such a way that the position and/or orientation of said one or more physical elements 12, 14, 16, 18, 20, 22 relative to the support structure 10 coincide with the position and/or orientation of the corresponding one or more physical elements in said virtual model;
interfacing said user with said electronic processing unit by means of a virtual reality viewer, wherein the aforesaid virtual model is displayed from a given point of view POV; acquiring and transmitting data indicative of the user's movements to said electronic processing unit.

In this way, the user will have the opportunity to completely immerse himself in the virtual environment, and to evaluate the ergonomic, structural and aesthetic conformity of the vehicle being tested.

The virtual model may be processed or acquired using, for example, a CAD/CAE/CAM platform.

The method further comprises the steps of:
defining a first reference point, the position of which relative to the support structure 10 is known; measuring a relative distance between said first reference point and a second reference point on the virtual reality viewer; and
positioning, through said processing unit, the POV point of view of the virtual reality viewer as a function of this relative distance.

According to an embodiment, the aforesaid step of arranging the one or more physical elements 12, 14, 16, 18, 20, 22, in such a way that their position and/or orientation coincide with the position and/or orientation of the corresponding one or more physical elements in said virtual model is performed by moving the one or more physical elements 12, 14, 16, 18, 20, 22 as a function of their distance from one or more predetermined reference points P, O, H, identified relative to the support structure 10, until the position and/or orientation of one or more physical elements 12, 14, 16, 18, 20, 22 coincide with the position and/or orientation that these parts of the apparatus have in the pre-processed or pre-acquired virtual model.

For example, the one or more physical elements 12, 14, 16, 18, 20, 22 may be moved until their position and/or orientation determine a specific arrangement of a user's heel relative to a heel point P, indicative of a standard position of the user's heel (as illustrated by way of example in Fig. 7A), and/or until their position and/or orientation determine a specific disposition of the user's foot relative to a heel point O, indicative of a position of the user's foot (as illustrated by way of example in Fig. 7B), and/or until their position and/or orientation determine a specific arrangement of a seat 12 relative to a seat point H, indicative of a rearmost and lowermost position of the seat relative to the front part of the vehicle (as illustrated by way of example in Fig. 8A and 8B). The position of such reference points P, O, H is generally predetermined according to conventional type-approval specifications.

Expediently, there is also the step, using said electronic processing unit, of processing the aforesaid virtual model and obtaining an integrated virtual model further comprising virtual elements, representative of elements inside and/or outside the vehicle, to simulate a real use condition of the vehicle. This step may be obtained, for example, by using a virtual rendering and prototyping software, such as the program commercially known as the acronym VRED^{™}, distributed by Autodesk.

According to an embodiment, the method further comprises the step of:
interfacing the user with a plurality of wearable sensors, each capable of transmitting a signal representative of its position and/or movement in space. It is possible to carry out this step, for example, by means of a photogrammetric system, by means of a so-called "motion capture" device, known per se.

According to an embodiment, the aforesaid step of arranging the physical elements 12, 14, 16, 18, 20, 22, according to the position and/or orientation assumed thereby in the virtual model, is carried out by means of electromechanical adjustment. Moreover, a test apparatus 9 for checking the arrangement of the physical elements of a vehicle comprises a support structure 10 to which the one or more physical elements 12, 14, 16, 18, 20, 22 are joined, the position and/or orientation of which are adjustable relative to the support structure 10, these physical elements comprising at least a seat 12, and/or a steering wheel 14, and/or a pedalboard 16, and/or a roof 18, and/or at least one door, and/or an armrest for a user of the test equipment, and/or a compartment used as a trunk; an electronic processing unit, configured to acquire or process the virtual model representative of an arrangement of the one or more physical elements 12, 14, 16, 18, 20, 22 relative to the support structure 10 of the test apparatus 9; a virtual reality viewer, adapted to view said virtual model from a given point of view POV; and acquisition and transmission means adapted, respectively, to acquire and transmit data indicative of the user's movements to said electronic processing unit. The electronic processing unit is configured to position the virtual reality viewer's point of view POV as a function of a relative distance between a first reference point, the position of which relative to the support structure 10 is known, and a second reference point on the virtual reality viewer.

According to an embodiment, said acquisition means comprise a plurality of wearable sensors (not shown), each adapted to transmit a signal representative of its position and/or its movement in space.

Expediently, the test apparatus 9 further comprises electromechanical adjustment means 26, adapted to adjust the position and/or orientation of the one or more internal physical elements 12, 14, 16, 18, 20, 22 relative to the support structure 10.

Preferably, the support structure 10 comprises rails 10a and/or telescopic columns 10b adapted to slidingly and/or pivotally support the one or more physical elements of the vehicle 12, 14, 16, 18, 20, 22.

According to a preferred embodiment, said electronic processing unit is further configured to process said virtual model to obtain an integrated virtual model further comprising virtual elements, representative of elements inside and/or outside the vehicle.

Various aspects and embodiments of a method and apparatus for checking and/or configuring the arrangement of the physical elements of a vehicle have been described, according to the invention. It is understood that each embodiment may be combined with any other embodiment. Furthermore, the invention is not limited to the described embodiments, but may be varied within the scope defined by the appended claims.

## Claims

1. Method for checking and/or configuring the arrangement of the physical elements of a vehicle, comprising the steps of:
a) providing a test apparatus (9) adapted to simulate the arrangement of the physical elements of the vehicle, said test apparatus (9) comprising a support structure (10) to which one or more physical elements (12, 14, 16, 18, 20, 22) are associated, the position and/or orientation of which may be adjusted relative to the support structure (10), said physical elements (12, 14, 16, 18, 20, 22) comprising one pedalboard (16) and at least one seat (12), and/or one steering wheel (14), and/or one roof (18), and/or at least one door, and/or one armrest for a user of the test apparatus (9), and/or one trunk compartment;
b1) acquiring or processing, by means of an electronic processing unit, a virtual model representative of an arrangement of the one or more physical elements (12, 14, 16, 18, 20, 22) relative to the support structure (10) of the test apparatus;
b2) interfacing said user with said electronic processing unit by means of a virtual reality viewer;
c) arranging the one or more physical elements (12, 14, 16, 18, 20, 22) according to said arrangement in step b1) in such a way that the position and/or orientation of said physical elements (12, 14, 16, 18, 20, 22) relative to the support structure (10) coincide with the position and/or orientation of the corresponding one or more physical elements in said virtual model, wherein said step c) is carried out by
- moving the one or more physical elements (12, 14, 16, 18, 20, 22) as a function of a distance of the same from one or more pre-determined reference points (P, O, H), identified relative to the support structure (10), until the position and/or orientation of the one or more physical elements (12, 14, 16, 18, 20, 22) coincides with the arrangement of the one or more physical elements (12, 14, 16, 18, 20, 22) relative to the support structure (10) in the virtual model acquired or processed in step b1),
- said one or more physical elements (12, 14, 16, 18, 20, 22) being moved until the position and/or orientation thereof determines a specific disposition of a user's heel relative to a particular one of the one or more pre-determined reference points, namely a heel point (P), indicative of a standard position of a user's heel, and wherein the method further comprises the steps of:
c1) defining a first reference point, the position of which relative to the support structure (10) is known;
c2) measuring a relative distance between said first reference point and a second reference point, said second reference point being on the virtual reality viewer;
c3) positioning, through said processing unit, a point of view (POV) of the virtual reality viewer as a function of the relative distance measured in said step c2);
d) displaying, by the virtual reality viewer, the virtual model referred to in step b1) from said point of view (POV); and
e) acquiring, and transmitting to said electronic processing unit, data indicative of the movements of the user.

2. Method according to claim 1, further comprising the step of:
f) processing, by means of said electronic processing unit, the virtual model obtained in step b1) and obtaining an integrated virtual model further comprising virtual elements, representative of elements inside and/or outside the vehicle, to simulate a real use condition of the vehicle.

3. Method according to any one of the preceding claims, further comprising the step of:
g) interfacing said user with a plurality of wearable sensors, each one being adapted to transmit a signal representative of its position and/or motion in space.

4. Method according to any one of the preceding claims, wherein said step c) of arranging the physical elements (12, 14, 16, 18, 20, 22) is carried out by electro-mechanical adjustment.

5. Test apparatus (9) configured for checking the arrangement of the physical elements of a vehicle, according to the method of any one of claims 1 to 4, comprising:
- a support structure (10) joined to one or more physical elements (12, 14, 16, 18, 20, 22) the position and/or orientation of which is adjustable relative to the support structure (10), said physical elements comprising at least a seat (12), and/or a steering wheel (14), and/or a pedalboard (16), and/or a roof (18), and/or at least one door, and/or an armrest for a user of the test apparatus, and/or a trunk compartment;
- an electronic processing unit configured for acquiring or processing a virtual model representative of an arrangement of the one or more physical elements (12, 14, 16, 18, 20, 22) relative to the support structure (10) of the test apparatus (9);
- a virtual reality viewer adapted to show said virtual model from a given point of view (POV); and
- acquisition and transmission means adapted respectively to acquire and transmit data, indicative of the movements of the user, to said electronic processing unit;
wherein said electronic processing unit is configured to position the point of view (POV) of the viewer according to a relative distance between a first reference point, the position of which relative to the support structure (10) is known, and a second reference point on the viewer.

6. Apparatus according to claim 5, wherein said acquisition means comprise a plurality of wearable sensors, each one being adapted to transmit a signal representative of its position and/or motion in space.

7. Apparatus according to claim 5 or 6, further comprising electromechanical adjustment means (26) adapted to adjust the position and/or orientation of the one or more internal physical elements (12, 14, 16, 18, 20, 22) relative to the support structure (10).

8. Apparatus according to any one of claims 5 to 7, wherein the support structure (10) comprises rails (10a) and/or telescopic columns (10b) adapted to slidingly and/or pivotally support the one or more physical elements of the vehicle (12, 14, 16, 18, 20, 22).

9. Apparatus according to any one of claims 5 to 8, wherein said electronic processing unit is further configured to process said virtual model so as to obtain an integrated virtual model further comprising virtual elements, representative of elements inside and/or outside the vehicle.

## Patentansprüche

1. Verfahren zum Prüfen und/oder Konfigurieren der Anordnung der physischen Elemente eines Fahrzeugs, umfassend die Schritte:
a) Bereitstellen einer Prüfvorrichtung (9), die dazu angepasst ist, die Anordnung der physischen Elemente des Fahrzeugs zu simulieren, wobei die Prüfvorrichtung (9) eine Tragstruktur (10) umfasst, der ein oder mehrere physische Elemente (12, 14, 16, 18, 20, 22) zugeordnet sind, deren Position und/oder Orientierung relativ zur Tragstruktur (10) einstellbar ist, wobei die physischen Elemente (12, 14, 16, 18, 20, 22) ein Pedalbrett (16) und mindestens einen Sitz (12) umfassen, und/oder ein Lenkrad (14), und/oder ein Dach (18), und/oder mindestens eine Tür, und/oder eine Armlehne für einen Benutzer der Prüfvorrichtung (9), und/oder ein Kofferraumfach;
b1) Erfassen oder Verarbeiten, mittels einer elektronischen Verarbeitungseinheit, eines virtuellen Modells, das eine Anordnung der einen oder mehreren physischen Elemente (12, 14, 16, 18, 20, 22) relativ zur Tragstruktur (10) der Prüfvorrichtung repräsentiert;
b2) Verbinden des Benutzers mit der elektronischen Verarbeitungseinheit mittels eines Virtual-Reality-Betrachters;
c) Anordnen des oder der physischen Elemente (12, 14, 16, 18, 20, 22) gemäß der Anordnung in Schritt b1) derart, dass die Position und/oder Orientierung der physischen Elemente (12, 14, 16, 18, 20, 22) relativ zur Tragstruktur (10) mit der Position und/oder Orientierung des oder der entsprechenden physischen Elemente im virtuellen Modell übereinstimmt, wobei Schritt c) durch Bewegen des oder der physischen Elemente (12, 14, 16, 18, 20, 22) in Abhängigkeit von einem Abstand von einem oder mehreren vorbestimmten Referenzpunkten (P, O, H) relativ zur Tragstruktur (10) durchgeführt wird, bis die Position und/oder Orientierung der physischen Elemente (12, 14, 16, 18, 20, 22) mit der Anordnung der physischen Elemente (12, 14, 16, 18, 20, 22) relativ zur Tragstruktur (10) im virtuellen Modell aus Schritt b1) übereinstimmt,
wobei die physischen Elemente (12, 14, 16, 18, 20, 22) so bewegt werden, dass deren Position und/oder Orientierung eine spezifische Anordnung der Ferse eines Benutzers relativ zu einem bestimmten der vorbestimmten Referenzpunkte bestimmt, nämlich einem Fersenpunkt (P), der eine Standardposition der Ferse eines Benutzers anzeigt, und wobei das Verfahren ferner die Schritte umfasst:
c1) Definieren eines ersten Referenzpunkts, dessen Position relativ zur Tragstruktur (10) bekannt ist;
c2) Messen eines relativen Abstands zwischen dem ersten Referenzpunkt und einem zweiten Referenzpunkt, wobei der zweite Referenzpunkt auf dem Virtual-Reality-Betrachter liegt;
c3) Positionieren, mittels der Verarbeitungseinheit, eines Blickpunkts (POV) des Virtual-Reality-Betrachters als Funktion des in Schritt c2) gemessenen relativen Abstands;
d) Anzeigen des virtuellen Modells aus Schritt b1) durch den Virtual-Reality-Betrachter von dem genannten Blickpunkt (POV);
e) Erfassen und Übermitteln an die elektronische Verarbeitungseinheit von Daten, die die Bewegungen des Benutzers anzeigen.

2. Verfahren nach Anspruch 1, ferner umfassend den Schritt:
f) Verarbeiten des in Schritt b1) erhaltenen virtuellen Modells mittels der elektronischen Verarbeitungseinheit und Erhalten eines integrierten virtuellen Modells, das virtuelle Elemente umfasst, die Elemente innerhalb und/oder außerhalb des Fahrzeugs repräsentieren, um eine reale Nutzungssituation des Fahrzeugs zu simulieren.

3. Verfahren nach einem der vorhergehenden Ansprüche, ferner umfassend den Schritt:
g) Verbinden des Benutzers mit einer Vielzahl tragbarer Sensoren, von denen jeder angepasst ist, ein Signal zu übertragen, das seine Position und/oder Bewegung im Raum repräsentiert.

4. Verfahren nach einem der vorhergehenden Ansprüche, wobei Schritt c) des Anordnens der physischen Elemente (12, 14, 16, 18, 20, 22) durch elektromechanische Anpassung durchgeführt wird.

5. Prüfvorrichtung (9), konfiguriert zum Prüfen der Anordnung der physischen Elemente eines Fahrzeugs gemäß dem Verfahren eines der Ansprüche 1 bis 4,
umfassend:
eine Tragstruktur (10), die mit einem oder mehreren physischen Elementen (12, 14, 16, 18, 20, 22) verbunden ist, deren Position und/oder Orientierung relativ zur Tragstruktur (10) einstellbar ist, wobei die physischen Elemente mindestens einen Sitz (12), und/oder ein Lenkrad (14), und/oder ein Pedalbrett (16), und/oder ein Dach (18), und/oder mindestens eine Tür, und/oder eine Armlehne für einen Benutzer der Prüfvorrichtung und/oder ein Kofferraumfach umfassen;
eine elektronische Verarbeitungseinheit, konfiguriert zum Erfassen oder Verarbeiten eines virtuellen Modells, das die Anordnung eines oder mehrerer physischer Elemente (12, 14, 16, 18, 20, 22) relativ zur Tragstruktur (10) der Prüfvorrichtung (9) repräsentiert;
einen Virtual-Reality-Betrachter, der angepasst ist, das virtuelle Modell aus einem gegebenen Blickpunkt (POV) anzuzeigen; und
Mittel zum Erfassen und Übermitteln, die jeweils angepasst sind, Daten zu erfassen und zu übertragen, die die Bewegungen des Benutzers anzeigen, an die elektronische Verarbeitungseinheit, wobei die elektronische Verarbeitungseinheit konfiguriert ist, den Blickpunkt (POV) des Betrachters in Abhängigkeit eines relativen Abstands zwischen einem ersten Referenzpunkt, dessen Position relativ zur Tragstruktur (10) bekannt ist, und einem zweiten Referenzpunkt auf dem Betrachter zu positionieren.

6. Vorrichtung nach Anspruch 5, wobei die Erfassungsmittel eine Vielzahl tragbarer Sensoren umfassen, von denen jeder angepasst ist, ein Signal zu übertragen, das seine Position und/oder Bewegung im Raum repräsentiert.

7. Vorrichtung nach Anspruch 5 oder 6, ferner umfassend elektromechanische Anpassungsmittel (26), die angepasst sind, die Position und/oder Orientierung der einen oder mehreren internen physischen Elemente (12, 14, 16, 18, 20, 22) relativ zur Tragstruktur (10) anzupassen.

8. Vorrichtung nach einem der Ansprüche 5 bis 7, wobei die Tragstruktur (10) Schienen (10a) und/oder Teleskopstützen (10b) umfasst, die angepasst sind, um die ein oder mehrere physischen Elemente des Fahrzeugs (12, 14, 16, 18, 20, 22) verschieblich und/oder schwenkbar zu tragen.

9. Vorrichtung nach einem der Ansprüche 5 bis 8, wobei die elektronische Verarbeitungseinheit ferner konfiguriert ist, das virtuelle Modell zu verarbeiten, um ein integriertes virtuelles Modell zu erhalten, das virtuelle Elemente umfasst, die Elemente innerhalb und/oder außerhalb des Fahrzeugs repräsentieren.

## Revendications

1. Procédé de vérification et/ou de configuration de l'agencement des éléments physiques d'un véhicule, comprenant les étapes consistant à :
a) fournir un appareil d'essai (9) adapté pour simuler l'agencement des éléments physiques du véhicule, ledit appareil d'essai (9) comprenant une structure de support (10) à laquelle un ou plusieurs éléments physiques (12, 14, 16, 18, 20, 22) sont associés, la position et/ou l'orientation desquels pouvant être ajustées par rapport à la structure de support (10), lesdits éléments physiques (12, 14, 16, 18, 20, 22) comprenant au moins un pédalier (16) et au moins un siège (12), et/ou un volant (14), et/ou un toit (18), et/ou au moins une porte, et/ou un accoudoir pour un utilisateur de l'appareil d'essai (9), et/ou un compartiment de coffre ;
b1) acquérir ou traiter, au moyen d'une unité de traitement électronique, un modèle virtuel représentatif d'un agencement du ou des éléments physiques (12, 14, 16, 18, 20, 22) par rapport à la structure de support (10) de l'appareil d'essai ;
b2) interfacer ledit utilisateur avec ladite unité de traitement électronique au moyen d'un visualiseur de réalité virtuelle ;
c) agencer le ou les éléments physiques (12, 14, 16, 18, 20, 22) conformément audit agencement de l'étape b1) de telle manière que la position et/ou l'orientation desdits éléments physiques (12, 14, 16, 18, 20, 22) par rapport à la structure de support (10) coïncide avec la position et/ou l'orientation du ou des éléments physiques correspondants dans ledit modèle virtuel, dans lequel ladite étape c) est effectuée en déplaçant le ou les éléments physiques (12, 14, 16, 18, 20, 22) en fonction d'une distance de ceux-ci par rapport à un ou plusieurs points de référence prédéterminés (P, O, H), identifiés par rapport à la structure de support (10), jusqu'à ce que la position et/ou l'orientation du ou des éléments physiques (12, 14, 16, 18, 20, 22) coïncide avec l'agencement du ou des éléments physiques (12, 14, 16, 18, 20, 22) par rapport à la structure de support (10) dans le modèle virtuel acquis ou traité à l'étape b1),
lesdits un ou plusieurs éléments physiques (12, 14, 16, 18, 20, 22) étant déplacés jusqu'à ce que la position et/ou l'orientation de ceux-ci détermine une disposition spécifique du talon d'un utilisateur par rapport à un élément particulier du ou des points de référence prédéterminés, à savoir un point de talon (P), indicatif d'une position standard du talon d'un utilisateur, et dans lequel le procédé comprend en outre les étapes consistant à :
c1) définir un premier point de référence, dont la position par rapport à la structure de support (10) est connue ;
c2) mesurer une distance relative entre ledit premier point de référence et un second point de référence, ledit second point de référence étant situé sur le visualiseur de réalité virtuelle,
c3) positionner, par l'intermédiaire de ladite unité de traitement électronique, un point de vue (POV) du visualiseur de réalité virtuelle en fonction de la distance relative mesurée à ladite étape c2) ;
d) afficher, par le visualiseur de réalité virtuelle, le modèle virtuel mentionné à l'étape b1) depuis ledit point de vue (POV), et
e) acquérir, et transmettre à ladite unité de traitement électronique, des données indicatives des mouvements de l'utilisateur.

2. Procédé selon la revendication 1, comprenant en outre l'étape consistant à :
f) traiter, au moyen de ladite unité de traitement électronique, le modèle virtuel obtenu à l'étape b1)
et obtenir un modèle virtuel intégré comprenant en outre des éléments virtuels, représentatifs d'éléments à l'intérieur et/ou à l'extérieur du véhicule, afin de simuler une condition d'utilisation réelle du véhicule.

3. Procédé selon l'une quelconque des revendications précédentes, comprenant en outre l'étape consistant à :
g) interfacer ledit utilisateur avec une pluralité de capteurs portables, chacun étant adapté pour transmettre un signal représentatif de sa position et/ou de son mouvement dans l'espace.

4. Procédé selon l'une quelconque des revendications précédentes, dans lequel ladite étape c) d'agencement des éléments physiques (12, 14, 16, 18, 20, 22) est effectuée par ajustement électromécanique.

5. Appareil d'essai (9) configuré
pour vérifier l'agencement des éléments physiques d'un véhicule, selon le procédé de l'une quelconque des revendications 1 à 4,
comprenant :
une structure de support (10) jointe à un ou plusieurs éléments physiques (12, 14, 16, 18, 20, 22) dont la position et/ou l'orientation est ajustable par rapport à la structure de support (10), lesdits éléments physiques comprenant au moins un siège (12), et/ou un volant (14), et/ou un pédalier (16), et/ou un toit (18), et/ou au moins une porte, et/ou un accoudoir pour un utilisateur de l'appareil d'essai, et/ou un compartiment de coffre ;
une unité de traitement électronique configurée pour acquérir ou traiter un modèle virtuel représentatif d'un agencement du ou des éléments physiques (12, 14, 16, 18, 20, 22) par rapport à la structure de support (10) de l'appareil d'essai (9) ;
un visualiseur de réalité virtuelle adapté pour afficher ledit modèle virtuel depuis un point de vue (POV) donné ; et
des moyens d'acquisition et de transmission adaptés respectivement pour acquérir et transmettre des données, indicatives des mouvements de l'utilisateur, à ladite unité de traitement électronique ;
dans lequel ladite unité de traitement électronique est configurée pour positionner le point de vue (POV) du visualiseur selon une distance relative entre un premier point de référence, dont la position par rapport à la structure de support (10) est connue, et un second point de référence sur le visualiseur.

6. Appareil selon la revendication 5, dans lequel lesdits moyens d'acquisition comprennent une pluralité de capteurs portables, chacun étant adapté pour transmettre un signal représentatif de sa position et/ou de son mouvement dans l'espace.

7. Appareil selon la revendication 5 ou 6, comprenant en outre des moyens d'ajustement électromécaniques (26) adaptés pour ajuster la position et/ou l'orientation du ou des éléments physiques internes (12, 14, 16, 18, 20, 22) par rapport à la structure de support (10).

8. Appareil selon l'une quelconque des revendications 5 à 7, dans lequel la structure de support (10) comprend des rails (10a) et/ou des colonnes télescopiques (10b) adaptées pour supporter de manière coulissante et/ou pivotante le ou les éléments physiques du véhicule (12, 14, 16, 18, 20, 22).

9. Appareil selon l'une quelconque des revendications 5 à 8, dans lequel ladite unité de traitement électronique est en outre configurée pour traiter ledit modèle virtuel de manière à obtenir un modèle virtuel intégré comprenant en outre des éléments virtuels, représentatifs d'éléments à l'intérieur et/ou à l'extérieur du véhicule.
